# EUROPEAN PATENT SPECIFICATION

(11) **EP 4 399 739 B1**
(45) Date of publication and mention of the grant of the patent: **29.10.2025**
(21) Application number: 22765956.2
(22) Date of filing: 05.09.2022
(51) Int. Cl.: H01L 21/67, H01L 21/687, C23C 16/458, C30B 25/12

(54) **SUBSTRATE CARRIER BORE HOLE PLUG**
SUBSTRATTRÄGER-BOHRLOCHSTOPFEN
BOUCHON DE TROU D'ALÉSAGE DE SUPPORT DE SUBSTRAT

(30) Priority: 06.09.2021 NL 2029133
(43) Date of publication of application: 17.07.2024
(73) Proprietor: Schunk Xycarb Technology B.V., 5705 CS Helmond (NL)
(72) Inventor: WIPPERLING, Moritz, 5705 CS HELMOND (NL); ANDON, Aslan, 5705 CS HELMOND (NL); VOLLMER, Andreas, 5705 CS HELMOND (NL); DE COCQ, Henricus Josephus Maria, 5705 CS HELMOND (NL)
(74) Representative: Algemeen Octrooi- en Merkenbureau B.V.
(86) International application number: PCT/NL2022/050498
(87) International publication number: WO 2023/033650

(56) References cited:
- EP-A2- 0 698 674
- US-A- 5 133 284
- US-A1- 2014 261 698
- US-A1- 2017 076 972

## Description

### Technical Field

The present invention relates generally to a substrate or wafer carrier configured for being used in a system for depositing thin films by means of Chemical Vapor Deposition (CVD) or Atomic Layer Deposition (ALD) on a substrate for manufacturing semiconductor components. More specifically relates the present invention to a substrate carrier with plugs for one or more bore holes.

### Background of the Invention

A substrate carrier as is used in chemical vapor deposition (CVD) processes for manufacturing semiconductor components. In a CVD or in an Atomic Layer Deposition (ALD) process a stack of thin layers composed of materials such as for example aluminum oxide, aluminum nitride, or gallium nitride are grown or deposited on for example a silicon, gallium nitride, or sapphire semiconductor substrate (also known as a wafer or wafer substrate), which semiconductor substrate is accommodated in a recessed pocket present in the deposition surface of the substrate carrier.

Such circular substrate carrier may have one single recessed pocked but typically have multiple recessed pockets, each for accommodating a single semiconductor substrate in an ALD process chamber as for example disclosed in US2017309512A1. In citation the recessed pockets for the semiconductor substrates to be processed are evenly distributed across the first, deposition surface side of the substrate carrier. Such substrate carrier system is generally referred to as a pancake batch carrier system.

In the CVD or ALD process the overall deposition surface of the substrate carrier including the semiconductor substrates accommodated in the recessed pockets are subjected to the deposition gases leading to the deposition of semiconductor layers on the exposed surface sides of the semiconductor substrates, but also on the remaining exposed area part of the deposition surface side of the substrate carrier neighboring the pockets (and the substrates).

Known wafer carriers are arranged for providing gas channels to the bottom of the recessed wafer pockets. These channels or gas distribution channels can serve the purpose of supplying purge gas to the recessed pockets in which the wafer is positioned. In other designs these gas channels may service a different or additional purpose of providing a vacuum channel. In any of these designs the wafer carrier is thus to be provided with a channel which is arranged to provide a gas or vacuum connection between the pockets and a supply or discharge manifold of the system.

Such gas channels within the wafer carrier are machined into the carrier in typically a manufacturing process of several steps which comprise machining first vertical channel sections within each pockets in a plane perpendicular to the bottom of the pocket which accommodates the wafer. Further, radially inward of the pockets near the spindle, or carrier hub, further vertical channel sections are provided or machined to provide the inlet or outlet ports of the channels from or towards the pockets and the first vertical channel sections provided therein. The final section of the channel, the horizontal channel section which connects both first and second vertical sections, is machined in a horizontal plane parallel to the main surface of the wafer carrier. As such a deep drilled gas channel hole is provided which extends from the side wall of the wafer carrier, towards the first vertical channel section up until the second vertical channel section such that a gas or fluid connection is provided between these first and second channel sections and thus between the pockets and a inlet/outlet on the bottom part, in or near the center of the wafer carrier and thus radially inward of the pockets.

Since gas being provided through this channel may escape to and from the opening in the side wall of the wafer carrier, these need to be closed off after drilling the hole. Typically, these holes are provided with a hole plug which is pushed in the gas channel and dimensioned in such a way that it remains in position through a press fit application. In order to make sure that the plug does not provide a negative effect on the process parameters of the CVD or ALD process, the plug it at least pressed into the channel up until it does not stick-out beyond the side wall or contour of the wafer carrier.

It has been found, however, that these known plugs have disadvantages, amongst which, to do alter the CVD or ALD process parameters, and most importantly, they have the tendency to get loose prior to the proposed end-of-life of the wafer carrier, which in turn may also cause further damage to the CVD or ALD system.

As such, there is a need for an improved wafer carrier design with gas channels providing a gas connection between the pockets and a gas in/outlet in or near the center of the wafer carrier and thus radially inward of the pocket, More specifically, there is a need for an improved wafer carrier design with improved gas channel bore hole plugs by which at least some of the above mentioned problems are obviated.

The following document is cited as being a pertinent prior art illustration:
Document US 2014/261698 A1 discloses a wafer carrier for use in system for growing epitaxial layers on wafers by chemical vapor deposition.

The following documents are also mentioned as a complementary prior art illustration:
US 5133284 A
US 2017/076972 A1
EP 0698674 A2

### Summary

In accordance with a first aspect of the present disclosure, there is provided a substrate carrier configured for being used , in a system for growing epitaxial layers on semiconductor substrates, said substrate carrier being a disk having a first surface side, comprising a plurality areas defined as substrate supports arranged for accommodating, during use, said semiconductor substrates, and wherein said substrate carrier further comprises a plurality of gas channels, extending radially inward of said disk and each providing a gas connection between each of the substrate supports and a center portion of the disk radially inward of the substrate supports, and wherein each of said gas channels consists of a bore hole arranged from a wall surface circumferential of the substrate carrier and provided with a bore hole plug, characterized in that said bore hole plug comprises a first and a separate second part, wherein at least a section of said first part has a shape mating said bore hole for press fitting at least said section of said first part in said bore hole, and wherein said second part is provided with interlocking means, and each bore hole is provided with a means corresponding to and arranged for receiving and mechanically retaining said interlocking means of said second part, and wherein said interlocking means of said bore hole is provided in said wall surface of said substrate carrier at an angle with respect to the longitudinal direction of said bore hole, for blocking said first bore hole plug part.

Wafer carrier or substrate carriers are known to have long or deep bore holes which are machined or drilled into the carrier to obtain gas channels, which extend radially through the substrate carrier. Each of these gas channels provides a gas connection between each of the substrate supports, e.g. recessed wafer pockets and a center portion of the substrate carrier radially inward of the substrate supports.

These gas channels thus start at a hub location and end in the deepest, most inner part of the substrate supports, preferably close to or in the center of the substrate supports. The gas channel is arranged to provide purge gas and/or a vacuum channel. In some embodiments, more common to MOCVD planetary systems, gas pushed through these channels will elevate and, in case of pockets provided with a spiral shaped pattern, rotate the wafers or disks which hold the wafers in these pockets. Hence, in all aspects and all examples the substrate supports are to be interpreted as any type of support for substrates, wafers, sub-carriers, hence, including and not limited to substrate carriers having pockets for accommodating substrates, or having means like spiral shaped patterns for levitating sub-carriers in a planetary disk type of configuration. The skilled person will appreciate that the proposed disclosure is applicable on these and any other type of such disk shaped carriers.

These gas channels or holes are drilled from the outer diameter or circumferential wall surface of the substrate carrier and plugged with a bore hole plug.

It has been found, however, that known bore hole plugs, which are press fitted into the bore hole do provide a tight fit, due to the press fitting method and due to accurate dimensions of both the bore hole as the bore hole plug. However, over time, the bore hole plug may become loose, which will eventually result in failure of the substrate carrier when the plug will fall out or cause gas leakage which influences the process parameters of the CVD, ALD, or MOCVD process in a negative manner.

The bore hole plug according to the present disclosure consists of two parts, one having close similarities to the known bore hole plugs, and being arranged for press fitting this part into the bore hole to ensure a gas-tight closure of the bore hole, whereas a second part is provided as an interlocking means, e.g. in the form of a blocking or stopping element to permanently lock the first part into position. The second bore hole plug part is a separate part and contrary to the first part preferably not arranged for solely press fitting but comprises an interlocking mechanism, like for example a bayonet, or threaded portion which can be received by a pocket in the bore hole of the substrate carrier having a corresponding interlocking means. Since the blocking or stopping element is provided at an inclination angle with respect the bore hole and thus the first bore hole plug part, it will ensure that the first bore hole plug part will not fall out of the wafer carrier, or even come loose in such a way that gas leakage can occur.

The use of the second bore hole plug part has several advantages. For example, with respect to redesigning known press fit bore hole plugs, the press fitting of at least a part of the bore hole plug is maintained as on the one hand this will ensure gas tight closing of the bore hole, where on the other hand, failure due to coming loose or falling out is prevented by the second bore hole plug part. Also, the second bore hole plug part is at least mostly placed in the corresponding bore hole in a direction which is not in-line or the forces acting upon the bore hole plug due to the gas pressure in the channel and the first bore hole plug part press-fitted into the bore. As the second part is at an angle with the first part, it is able to withstand more pressure than a single part or two (separate) parts which are placed in-line with the bore hole. Moreover, the proposed bore hole plug only requires some additional machining steps for which no additional equipment or tools are required besides those that are already required for machining the original bore hole and known bore hole plugs. Further, the bore hole and thus gas channel do not require modification thus not affecting the process parameters of the CVD, ALD or MOCVD process. Finally, the proposed bore hole plug is also arranged for post-processing at least the second bore hole plug part to make sure the bore hole plug is flush with the wall surface of the substrate carrier.

In an example, the wall surface of said substrate carrier is sloped towards a second surface side of said substrate carrier opposite said first surface side.

In an example, said thread of said bore hole is provided in said substrate carrier after at least said section of said first part is press fitted in said bore hole.

In an example, said second part of said bore hole plug is, in after being provided in the bore hole, in contact with the first part of said bore hole plug.

In an example, said second part of the bore hole plug has a head section for receiving a tool for screwing said threaded section into said thread of said bore hole.

In an example, said head section for receiving said tool comprises a polygon shaped tool receiving section extending from said head section, and wherein said tool receiving section preferably is arranged, after being provided in thread of the bore, to extend said wall surface of said substrate carrier.

In an example, said interlocking means comprise one or more of a threaded fastening means, screw fastening means, press-fit fastening means, rotational fastening means, bayonet mount fastening means, key or pin fastening means and shrink-fit fastening means.

In an example, said angle of said interlocking means of said bore hole with respect to the longitudinal direction of said bore hole is approximately one or more of 30 degrees, 45 degrees, 60 degrees, 90 degrees , 120 degrees, 135 degrees or 150 degrees.

In an example, said substrate carrier is comprised of graphite.

In an example, said substrate carrier is comprises of a graphite core covered by a silicon carbide coating.

In an example, one or both of said first and second bore hole plug parts is comprised of graphite.

In a second aspect of the present disclosure, there is provided a method of manufacturing a substrate carrier configured for being used in a system for depositing layers on semiconductor substrates, comprising the steps of:
- providing a substrate carrier having a first surface side, an area part of said first surface side being provided with recessed wafer pockets for accommodating, during use, said semiconductor substrates,
- machining a first bore hole section in each of said wafer pockets at least substantially perpendicular to the first surface side of the substrate carrier;
- machining a second bore hole section from a wall surface circumferential of the substrate carrier extending radially through said substrate carrier for providing a gas connection between each of the first bore hole sections in the recessed wafer pockets and a center portion of the substrate carrier radially inward of the recessed wafer pockets;
- press fitting a first bore hole plug part into the second bore hole section;
- machining a pocket for a second bore hole plug part into the wall surface of the substrate carrier, wherein said pocket is provided with a thread and arranged at an angle with respect to the longitudinal direction of the bore hole;
- screwing in a second bore hole plug part which is at least partially provided with a threaded section corresponding to said thread of said pocket, for blocking said first bore hole plug part.

In an example, said method further, prior to said step of press fitting said first bore hole plug part, comprises the step of:
- machining a chamfer on said wall surface of said substrate carrier.

In an example, said second bore hole plug part comprises a polygon shaped tool receiving section extending from said head section and wherein said method further, after said step of screwing in said second bore hole plug part, comprises the step of:
- machining said wall surface of said substrate carrier by removing said tool receiving section extending from said wall surface of said substrate carrier for making said second bore hole plug part flush with said wall surface of said substrate carrier.

In an example, said method further, after said step of screwing in said second bore hole plug part, comprises the step of:
- providing a coating of silicon carbide of at least said wall surface of said substrate carrier, and more in particular over covering all of said substrate carrier.

In an example, one or both of said first and second bore hole plug parts is comprised of graphite.

The invention will now be described in more detail by means of specific embodiments, with reference to the enclosed drawings, wherein equal or like parts and/or components are designated by the same reference numerals. The invention is in no manner whatsoever limited to the embodiments disclosed.

### Brief description of the Drawings

Fig. 1 shows schematically a top view of elements of a substrate carrier according to the first aspect of the present disclosure;
Fig. 2 shows a cross-sectional side view of the cross section A-A of Fig. 1;
Fig. 3 shows in more detail an isometric view of the encircled section of Fig. 2;
Fig. 4 shows schematically an isometric view of a section of a substrate carrier and a bore hole plug according to the first aspect of the present disclosure;
Fig. 5 shows schematically an isometric view of the section of Fig. 4 wherein the bore plugged is attached to the substrate carrier;
Fig. 6 shows schematically an isometric view of a coated section of substrate carrier according to the first aspect of the present disclosure;
Fig. 7 shows schematically a cross-sectional view of the coated section of Fig. 6;
Fig. 8 shows an overview of a method of manufacturing a substrate carrier according to the second aspect of the present disclosure.

### Detailed Description

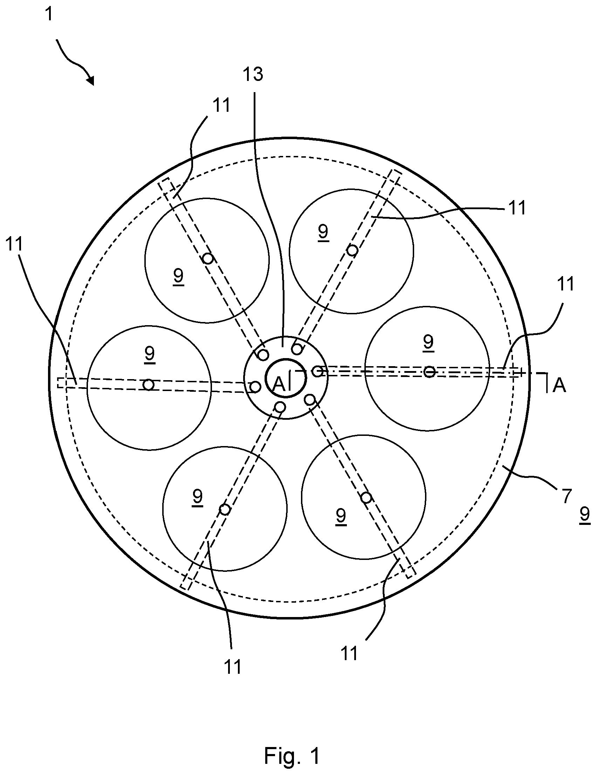

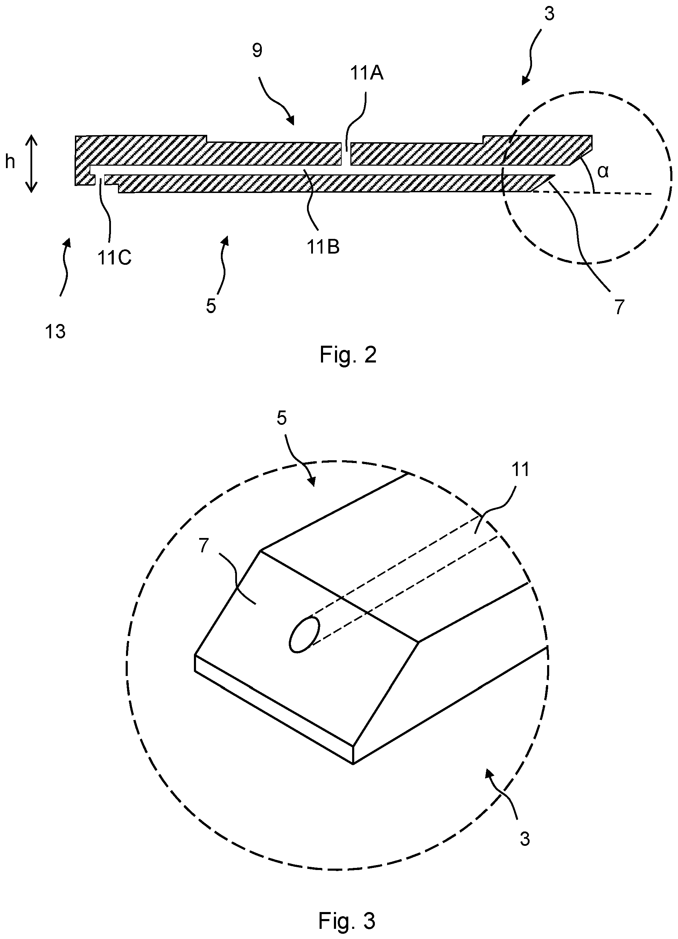

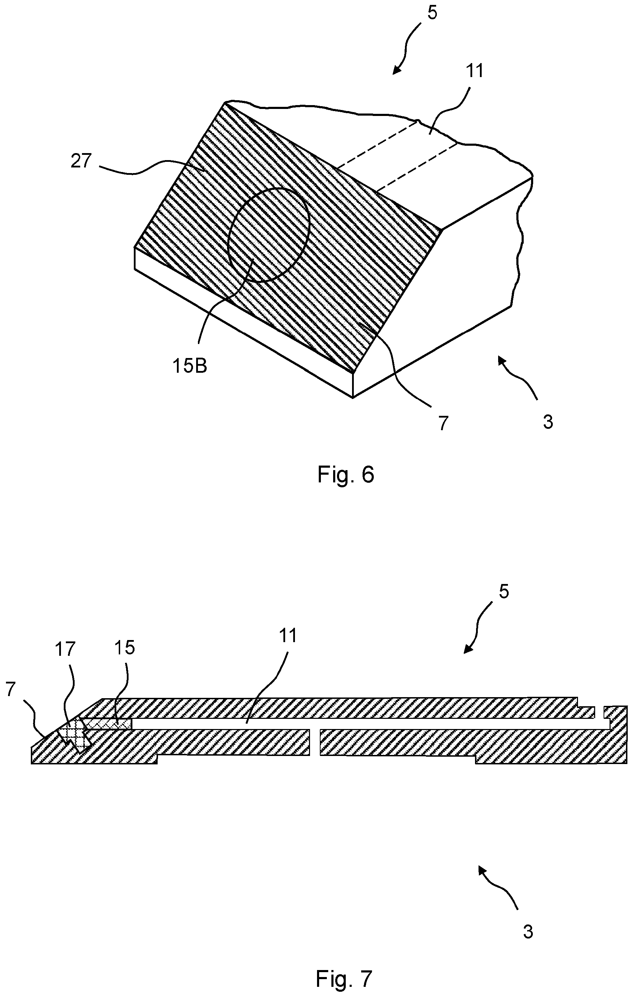

Figure 1 shows schematically a top view of a substrate carrier 1 configured for being used in a system for growing epitaxial layers on semiconductor substrates. Figure 2 shows the cross-sectional view of cross section indicated by A-A in figure 1, wherein the encircled section in figure 2 is shown in more detail by the isometric view of figure 3. The substrate carrier 1 is a substrate carrier or (planetary) disk comprised of graphite, having a first surface side 3 and a second surface side 5. The first surface side 3 is the top side as shown in figure 1. The second surface side 5 is located opposite to the first surface side 3. The wall surface 7 circumferential of the substrate carrier 1 is sloped towards the second surface 5, at an angle α relative to the plane parallel to the first surface side 3 and the second surface side 5 of the substrate carrier 1. Notice that in figures 3 - 7, for illustrative purpose, the first surface side 3 and the second surface side 5 are flipped relative to figure 1 and figure 2. In the embodiment shown in the figure 1, the substrate carrier 1 comprises six areas which are defined as substrate supports (9) arranged for accommodating, during use the semiconductor substrates.

The substrate carrier 1 further comprises six internal gas channels 11. The gas channels 11 extending radially inward of the planetary disk. Each gas channel 11 provides a gas connection between each of the substrate supports 9 and a center portion 13 of the planetary disk radially inward of the substrate supports 9. Each of the gas channels 11 comprises a first bore hole section 11A, a second bore hole section 11B, and a third bore hole section 11C. From each substrate supports 9, the first section 11A extends perpendicular to the first surface side 3 of the substrate carrier 1, inwards the substrate carrier 1, approximately up to half of the height h of the substrate carrier 1. From the center portion 13, the third section 11C extends perpendicular to the second surface 5 of the substrate carrier 1, inwards the substrate carrier 1, approximately up to half of the height h of the substrate carrier 1. The second section 11B of the gas channel 11 consists of a circularly bore hole arranged from the wall surface 7 extending radially inward the substrate carrier 1, thereby fluidly connecting the first section 11A and the third section 11C of each gas channel 11.

In order to close and seal the opening of the gas channels 11 in the wall surface 7 of the substrate carrier 1, the substrate carrier 1 is provided with a bore hole plug. The bore hole plug comprises a first part 15 and a separate second part 17, both comprised of graphite. The first part 15 has a shape mating the bore hole of the gas channel 11 for press fitting the first part 15 in the bore hole. The first part 15 is inserted in its longitudinal direction into the gas channel 11 such that the opening of the specific gas channel 11 in the wall surface of the substrate carrier 1 is closed and sealed. Due to the pressure of the gas present in the gas channel 11, when the substrate carrier is in use, the pressed fitted first part 15 of the bore hole plug can be pushed out of the gas channel 11. To prevent this, the bore hole plug is provided with a second part 17.

The second part 17 of the bore hole plug comprises a circular shaped top section 19 and a circular shaped interlocking section 21, wherein the diameter of the interlocking section 21 is smaller than the diameter of the top section 19. The interlocking section 21 is provided with an interlocking feature, preferably a screw thread. The top section 19 is provided with a polygon shaped head section 23 for receiving an appropriate polygon shaped tool.

For interlocking the second part 17 of the bore hole plug to the substrate carrier 1, the substrate carrier 1 is provided with a pocket 25. The pocket 25 is machined into the substrate carrier 1, wherein pocket 25 extends perpendicular to the sloped wall section 7 inwards the substrate carrier 1. The depth and the diameters of the pocket 25 correspond to the length and the diameters of the respective top section 19 and the respective interlocking section 21 of the second part 17 of the bore hole plug.

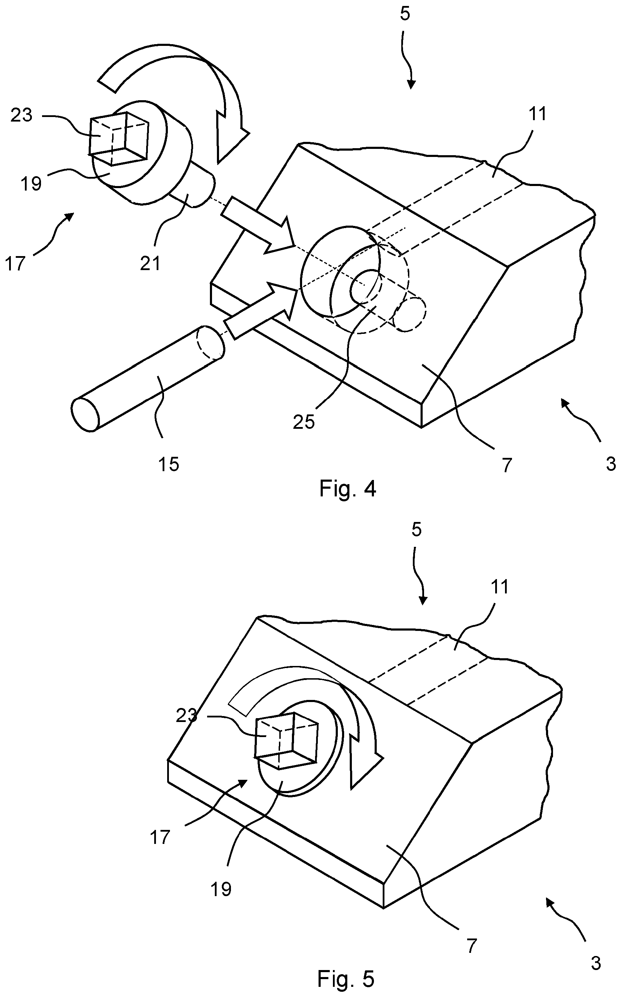

The section of the pocket 25 corresponding to the interlocking section 21 of the second part 17 of the bore hole plug is provided with means corresponding to and arranged for receiving and mechanically retaining the interlocking section 21 of the second part 17 of the bore hole plug. Preferably, the means comprise a thread corresponding to the screw thread of the interlocking section 21 of the second part 17 of the bore hole plug. With the use of the appropriate polygon shaped tool, the second part 17 of the bore hole plug is screwed into the thread of the pocket 25, by rotating the second part 17 of the bore hole plug clockwise relative to its central axis, as indicated in figures 4 and 5.

Preferably, the pocket 25 is provided into the substrate carrier 1 after the first part 15 of the bore hole plug is press fitted in the bore hole of the gas channel 11, such that the second part 17 of the bore hole plug is, in after being provided in the pocket 25, in corresponding contact with the first part 15 of the bore hole plug and thereby blocking the first part 15 of the bore hole plug for exiting the respective gas channel 11. When the second part 17 of the bore plug is firmly provided into the pocket 25, the section of the second part 17 of the bore plug that protrudes the sloped wall section 7 is removed, after which the substrate carrier 1 is coated by a silicon carbide coating 27. The result is an invisible plug location firmly fixed into the gas channel 11, that cannot be pushed out of its position.

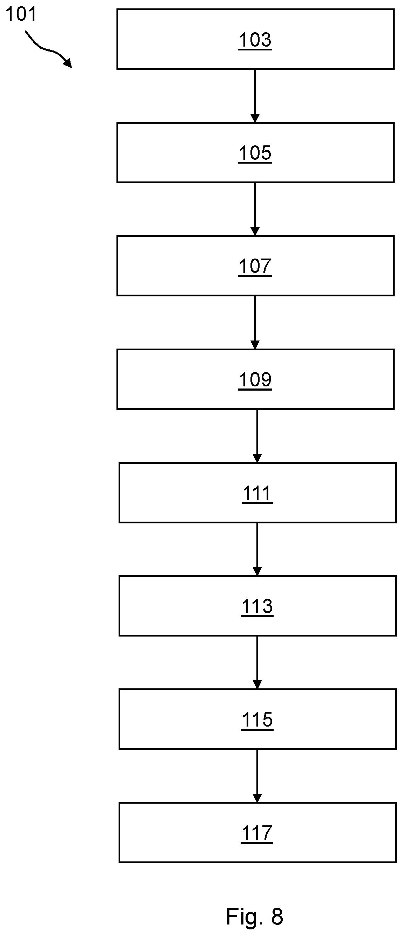

Figure 8 shows a method 101 of manufacturing the substrate carrier 1 configured for being used in a system for growing epitaxial layers on semiconductor substrates by chemical vapor deposition. In a first step 103 of the method 1, the substrate carrier 1 is provided. The area part of the first surface side 3 of the substrate carrier 1 is provided with substrate supports 9 for accommodating, during use, the semiconductor substrates.

In a second step 105 of the method 101, the first bore hole section 11A is machined in each of the substrate supports at least substantially perpendicular to the first surface side of the substrate carrier.

In a third step 107 of the method 101, the second bore hole section 11B is machined from the wall surface 7 circumferential of the substrate carrier 1 extending radially through the substrate carrier 1 for providing the gas connection between each of the first bore hole sections 11A in the substrate supports and the center portion 13 of the substrate carrier 1 radially inward of the substrate supports.

Additionally, a chamfer is machined on the wall surface 7 of the substrate carrier 1 during a fourth step 109 of the method 101.

In a fifth step 111 of the method 101, the first bore hole plug part 15 is press fitted into the second bore hole section 11B.

After the first bore hole plug 15 is press fitted into the second bore hole section, the pocket 25 for the second bore hole plug part 17 is machined into the wall surface 7 of the substrate carrier 1 during a fifth step 113 of the method 101, wherein the pocket 25 is provided with a thread and arranged at an angle with respect to the longitudinal direction of the bore hole.

During a sixth step 113 of the method 101, the second bore hole plug part 17, which is at least partially provided with a threaded section corresponding to the thread of the pocket 25, is screwed in the pocket 25, for blocking the first bore hole plug part 15.

Eventually, the substrate carrier 1 is finished, by machining the wall surface 7 of the substrate carrier 1 by removing the tool receiving section 23 extending from the wall surface 7 of the substrate carrier 1 for making the second bore hole plug part 17 flush with the wall surface 7 of the substrate carrier 1 during a seventh step 115 of the method 101.

In a last step 117 of the method 101, the substrate carrier 1 is provided with a coating of silicon carbide.

Based on the above description, a skilled person may provide modifications and additions to the method and arrangement disclosed, which modifications and additions are all comprised by the scope of the appended claims, said claims defining the invention.

## Claims

1. A substrate carrier (1) configured for being used in a system for growing epitaxial layers on semiconductor substrates, said substrate carrier being a disk having a first surface side (3), -comprising a plurality areas defined as substrate supports (9) arranged for accommodating, during use, said semiconductor substrates, and wherein said substrate carrier further comprises a plurality of gas channels (11), extending radially inward of said disk and each providing a gas connection between each of the substrate supports and a center portion (13) of the disk radially inward of the substrate supports, and wherein each of said gas channels consists of a bore hole arranged from a wall surface (7) circumferential of the substrate carrier and provided with a bore hole plug, **characterized in that** said bore hole plug comprises a first and a separate second part (15 and 17),
wherein at least a section of said first part has a shape mating said bore hole for press fitting at least said section of said first part (15) in said bore hole, and
wherein said second part (17) is provided with interlocking means, and each bore hole is provided with a means corresponding to and arranged for receiving and mechanically retaining said interlocking means of said second part, and wherein said interlocking means of said bore hole is provided in said wall surface of said substrate carrier at an angle with respect to the longitudinal direction of said bore hole, for blocking said first bore hole plug part (15).

2. The substrate carrier according to claim 1, wherein the wall surface of said substrate carrier is sloped towards a second surface side of said substrate carrier opposite said first surface side.

3. The substrate carrier according to claim 1 or 2, wherein said thread of said bore hole is provided in said substrate carrier after at least said section of said first part is press fitted in said bore hole.

4. The substrate carrier according to any of the previous claims, wherein said second part of said bore hole plug is, in after being provided in the bore hole, in contact with the first part of said bore hole plug.

5. The substrate carrier according to any of the previous claims, wherein said second part of the bore hole plug has a head section for receiving a tool for screwing or otherwise rotationally interlocking said section into said thread of said bore hole, , wherein preferably said head section for receiving said tool comprises a polygon shaped tool receiving section extending from said head section, and wherein said tool receiving section preferably is arranged, after being provided in thread of the bore, to extend said wall surface of said substrate carrier.

6. The substrate carrier according to any of the previous claims, wherein said interlocking means comprise one or more of a threaded fastening means, screw fastening means, press-fit fastening means, rotational fastening means, bayonet mount fastening means, key or pin fastening means and shrink-fit fastening means.

7. The substrate carrier according to any of the previous claims, wherein said angle of said interlocking means of said bore hole with respect to the longitudinal direction of said bore hole is approximately one or more of 30 degrees, 45 degrees, 60 degrees, 90 degrees , 120 degrees, 135 degrees or 150 degrees.

8. The substrate carrier according to any of the previous claims, wherein said substrate carrier is comprised of graphite, wherein preferably said substrate carrier is comprises of a graphite core covered by a silicon carbide coating.

9. The substrate carrier according to any of the previous claims, wherein said first bore hole plug part is comprised of a graphite.

10. The substrate carrier according to any of the previous claims, wherein said second bore hole plug part is comprised of a graphite.

11. Method of manufacturing a substrate carrier for use in a system for growing thin film layers on semiconductor substrates by chemical vapor deposition, comprising the steps of:
- providing a substrate carrier (1) having a first surface side (3), an area part of said first surface side being provided with substrate supports (9) for accommodating during use, said semiconductor substrates,
- machining a first bore hole section (11A) in each of said substrate supports at least substantially perpendicular to the first surface side of the substrate carrier;
- machining a second bore hole section (11B) from a wall surface (7) circumferential of the substrate carrier extending radially through said substrate carrier for providing a gas connection between each of the first bore hole sections in the substrate supports and a center portion (13) of the substrate carrier radially inward of the substrate supports;
- press fitting a first bore hole plug part (15) into the second bore hole section;
- machining a pocket (25) for a second bore hole plug part (17) into the wall surface of the substrate carrier, wherein said pocket is provided with a thread and arranged at an angle with respect to the longitudinal direction of the bore hole of the second bore hole section (11B)
- screwing in the second bore hole plug part which is at least partially provided with a threaded section corresponding to said thread of said pocket, for blocking said first bore hole plug part.

12. Method of manufacturing a substrate carrier according to claim 11, wherein said method further, prior to said step of press fitting said first bore hole plug part, comprises the step of:
- machining a chamfer on said wall surface of said substrate carrier.

13. Method of manufacturing a substrate carrier according to any of the previous claims 11-12, wherein said second bore hole plug part comprises a polygon shaped tool receiving section extending from said head section and wherein said method further, after said step of screwing in said second bore hole plug part, comprises the step of:
- machining said wall surface of said substrate carrier by removing said tool receiving section extending from said wall surface of said substrate carrier for making said second bore hole plug part flush with said wall surface of said substrate carrier.

14. Method of manufacturing a substrate carrier according to any of the claims 11-13, wherein said method further, after said step of screwing in said second bore hole plug part, comprises the step of:
- providing a coating of silicon carbide of at least said wall surface of said substrate carrier, and more in particular over covering all of said substrate carrier.

15. Method of manufacturing a substrate carrier according to any of the claims 11-14, wherein one or both of said first and second bore hole plug parts is comprised of graphite.

## Patentansprüche

1. Substratträger (1), der dazu ausgelegt ist, in einem System zum Züchten epitaktischer Schichten auf Halbleitersubstraten verwendet zu werden, wobei der Substratträger eine Scheibe mit einer ersten Oberflächenseite (3) ist, die eine Vielzahl von Bereichen umfasst, die als Substratträger (9) definiert sind, die angeordnet sind, um während der Verwendung die Halbleitersubstrate unterzubringen, und wobei der Substratträger ferner eine Vielzahl von Gaskanälen (11) umfasst, die sich radial einwärts von der Scheibe erstreckt und jeweils eine Gasverbindung zwischen jedem der Substratträger und einem Mittelteil (13) der Scheibe radial einwärts von den Substratträgern bereitstellen, und wobei jeder der Gaskanäle aus einem Bohrloch besteht, das von einer Wandoberfläche (7), die den Substratträger umfänglich umgibt und mit einem Bohrlochstopfen versehen ist, angeordnet ist, **dadurch gekennzeichnet, dass** der Bohrlochstopfen ein erstes und ein separates zweites Teil (15 und 17) umfasst, wobei zumindest ein Abschnitt des ersten Teils eine Form aufweist, die mit dem Bohrloch zusammenpasst, um zumindest den Abschnitt des ersten Teils (15) in das Bohrloch einzupressen, und wobei das zweite Teil (17) mit Verriegelungsmitteln versehen ist, und jedes Bohrloch mit einem Mittel versehen ist, das dem Verriegelungsmittel des zweiten Teils entspricht und angeordnet ist, um das Verriegelungsmittel des zweiten Teils aufzunehmen und mechanisch zu halten, und wobei das Verriegelungsmittel des Bohrlochs in der Wandoberfläche des Substratträgers in einem Winkel in Bezug auf die Längsrichtung des Bohrlochs bereitgestellt wird, um das erste Bohrlochstopfenteil (15) zu blockieren.

2. Substratträger nach Anspruch 1, wobei die Wandoberfläche des Substratträgers zu einer zweiten Oberflächenseite des Substratträgers gegenüber der ersten Oberflächenseite geneigt ist.

3. Substratträger nach Anspruch 1 oder 2, wobei das Gewinde des Bohrlochs in dem Substratträger bereitgestellt wird, nachdem zumindest der Abschnitt des ersten Teils in das Bohrloch eingepresst wurde.

4. Substratträger nach einem der vorhergehenden Ansprüche, wobei das zweite Teil des Bohrlochstopfens, nachdem es in dem Bohrloch bereitgestellt wurde, in Kontakt mit dem ersten Teil des Bohrlochstopfens ist.

5. Substratträger nach einem der vorhergehenden Ansprüche, wobei das zweite Teil des Bohrlochstopfens einen Kopfabschnitt zum Aufnehmen eines Werkzeugs zum Einschrauben oder anderweitigen Drehverriegeln des Abschnitts in das Gewinde des Bohrlochs hinein aufweist, wobei vorzugsweise der Kopfabschnitt zum Aufnehmen des Werkzeugs einen polygonförmigen Werkzeugaufnahmeabschnitt umfasst, der sich von dem Kopfabschnitt erstreckt, und wobei der Werkzeugaufnahmeabschnitt vorzugsweise, nachdem er in einem Gewinde der Bohrung bereitgestellt worden ist, angeordnet ist, um die Wandoberfläche des Substratträgers zu verlängern.

6. Substratträger nach einem der vorhergehenden Ansprüche, wobei die Verriegelungsmittel eines oder mehrere von einem Gewindebefestigungsmittel, Schraubenbefestigungsmittel, Einpressbefestigungsmittel, Drehbefestigungsmittel, Bajonettbefestigungsmittel, Keil- oder Stiftbefestigungsmittel und Schrumpfsitz-Befestigungsmittel umfassen.

7. Substratträger nach einem der vorhergehenden Ansprüche, wobei der Winkel der Verriegelungsmittel des Bohrlochs in Bezug zu der Längsrichtung des Bohrlochs ungefähr eines oder mehrere von 30 Grad, 45 Grad, 60 Grad, 90 Grad, 120 Grad, 135 Grad oder 150 Grad beträgt.

8. Substratträger nach einem der vorhergehenden Ansprüche, wobei der Substratträger aus Graphit zusammengesetzt ist, wobei der Substratträger vorzugsweise aus einem Graphitkern, der mit einer Siliciumcarbidbeschichtung bedeckt ist, zusammengesetzt ist.

9. Substratträger nach einem der vorhergehenden Ansprüche, wobei das erste Bohrlochstopfenteil aus einem Graphit zusammengesetzt ist.

10. Substratträger nach einem der vorhergehenden Ansprüche, wobei das zweite Bohrlochstopfenteil aus einem Graphit zusammengesetzt ist.

11. Verfahren zum Fertigen eines Substratträgers zur Verwendung in einem System zum Züchten von Dünnfilmschichten auf Halbleitersubstraten durch chemische Gasphasenabscheidung, umfassend die Schritte:
- Bereitstellen eines Substratträgers (1) mit einer ersten Oberflächenseite (3), wobei ein Bereichsteil der ersten Oberflächenseite mit Substratträgern (9) zum Unterbringen der Halbleitersubstrate während der Verwendung versehen ist,
- maschinelles Bearbeiten eines ersten Bohrlochabschnitts (11A) in jedem der Substratträger zumindest im Wesentlichen senkrecht zu der ersten Oberflächenseite des Substratträgers;
- maschinelles Bearbeiten eines zweiten Bohrlochabschnitts (11B) von einer Wandoberfläche (7), die den Substratträger umfänglich umgibt und sich radial durch den Substratträger erstreckt, um eine Gasverbindung zwischen jedem der ersten Bohrlochabschnitte in den Substratträgern und einem Mittelteil (13) des Substratträgers radial einwärts der Substratträger bereitzustellen;
- Einpressen eines ersten Bohrlochstopfenteils (15) in den zweiten Bohrlochabschnitt;
- maschinelles Bearbeiten einer Tasche (25) für ein zweites Bohrlochstopfenteil (17) in die Wandoberfläche des Substratträgers hinein, wobei diese Tasche mit einem Gewinde versehen und in einem Winkel in Bezug zu der Längsrichtung des Bohrlochs des zweiten Bohrlochabschnitts (11B) angeordnet ist;
- Einschrauben des zweiten Bohrlochstopfenteils, das zumindest teilweise mit einem Gewindeabschnitt versehen ist, welcher dem Gewinde der Tasche entspricht, zum Blockieren des ersten Bohrlochstopfenteils.

12. Verfahren zum Fertigen eines Substratträgers nach Anspruch 11, wobei das Verfahren ferner vor dem Schritt des Einpressens des ersten Bohrlochstopfenteils den folgenden Schritt umfasst:
- maschinelles Bearbeiten einer Fase auf der Wandoberfläche des Substratträgers.

13. Verfahren zum Fertigen eines Substratträgers nach einem der vorhergehenden Ansprüche 11-12, wobei das zweite Bohrlochstopfenteil einen polygonförmigen Werkzeugaufnahmeabschnitt umfasst, der sich von dem Kopfabschnitt erstreckt, und wobei das Verfahren ferner nach dem Schritt des Einschraubens des zweiten Bohrlochstopfenteils den folgenden Schritt umfasst:
- maschinelles Bearbeiten der Wandoberfläche des Substratträgers durch Entfernen des Werkzeugaufnahmeabschnitts, der sich von der Wandoberfläche des Substratträgers erstreckt, um das zweite Bohrlochstopfenteil bündig mit der Wandoberfläche des Substratträgers zu machen.

14. Verfahren zum Fertigen eines Substratträgers nach einem der Ansprüche 11-13, wobei das Verfahren ferner nach dem Schritt des Einschraubens des zweiten Bohrlochstopfenteils den folgenden Schritt umfasst:
- Bereitstellen einer Beschichtung aus Siliciumcarbid auf zumindest der Wandoberfläche des Substratträgers und insbesondere über der Abdeckung des gesamten Substratträgers.

15. Verfahren zum Fertigen eines Substratträgers nach einem der Ansprüche 11-14, wobei eines oder beide der ersten und zweiten Bohrlochstopfenteile aus Graphit zusammengesetzt ist/sind.

## Revendications

1. Porte-substrat (1) configuré pour être utilisé dans un système de croissance de couches épitaxiales sur des substrats semi-conducteurs, ledit porte-substrat étant un disque ayant un premier côté surface (3), comprenant une pluralité de zones définies comme supports de substrat (9) agencées pour recevoir, en cours d'utilisation, lesdits substrats semi-conducteurs, et où ledit porte-substrat comprend en outre une pluralité de canaux de gaz (11), s'étendant radialement vers l'intérieur dudit disque et fournissant chacun un raccordement de gaz entre chacun des supports de substrat et une partie centrale (13) du disque radialement vers l'intérieur des supports de substrat, et où chacun desdits canaux de gaz est constitué d'un trou d'alésage agencé depuis une surface de paroi (7) circonférentielle du porte-substrat et muni d'un bouchon de trou d'alésage, **caractérisé en ce que** ledit bouchon de trou d'alésage comprend une première partie et une seconde partie séparée (15 et 17),
dans lequel au moins une section de ladite première partie a une forme correspondant audit trou d'alésage pour un ajustement serré d'au moins ladite section de ladite première partie (15) dans ledit trou d'alésage, et
dans lequel ladite seconde partie (17) est munie d'un moyen de verrouillage, et chaque trou d'alésage est muni d'un moyen correspondant à et agencé pour recevoir et retenir mécaniquement ledit moyen de verrouillage de ladite seconde partie, et dans lequel ledit moyen de verrouillage dudit trou d'alésage est prévu dans ladite surface de paroi dudit porte-substrat à un angle par rapport à la direction longitudinale dudit trou d'alésage, pour bloquer ladite première partie de bouchon de trou d'alésage (15).

2. Porte-substrat selon la revendication 1, dans lequel la surface de paroi dudit porte-substrat est inclinée vers un second côté surface dudit porte-substrat opposé audit premier côté surface.

3. Porte-substrat selon la revendication 1 ou 2, dans lequel ledit filetage dudit trou d'alésage est prévu dans ledit porte-substrat après un ajustement serré d'au moins ladite section de ladite première partie dans ledit trou d'alésage.

4. Porte-substrat selon l'une des revendications précédentes, dans lequel ladite seconde partie dudit bouchon de trou d'alésage est, après avoir été prévue dans le trou d'alésage, en contact avec la première partie dudit bouchon de trou d'alésage.

5. Porte-substrat selon l'une des revendications précédentes, dans lequel ladite seconde partie du bouchon de trou d'alésage a une section de tête pour recevoir un outil pour visser ou autrement verrouiller en rotation ladite section dans ledit filetage dudit trou d'alésage, dans lequel, de préférence, ladite section de tête pour recevoir ledit outil comprend une section de réception d'outil en forme de polygone s'étendant depuis ladite section de tête, et dans lequel ladite section de réception d'outil est de préférence agencée, après avoir été prévue dans le filetage du trou, de manière à étendre ladite surface de paroi dudit porte-substrat.

6. Porte-substrat selon l'une des revendications précédentes, dans lequel ledit moyen de verrouillage comprend un ou plusieurs des moyens de fixation filetés, des moyens de fixation à vis, des moyens de fixation à ajustement serré, des moyens de fixation rotatifs, des moyens de fixation à monture à baïonnette, des moyens de fixation à clavette ou à goupille et des moyens de fixation à ajustement fretté.

7. Porte-substrat selon l'une des revendications précédentes, dans lequel ledit angle dudit moyen de verrouillage dudit trou d'alésage par rapport à la direction longitudinale dudit trou d'alésage est approximativement un ou plusieurs parmi 30 degrés, 45 degrés, 60 degrés, 90 degrés, 120 degrés, 135 degrés ou 150 degrés.

8. Porte-substrat selon l'une des revendications précédentes, dans lequel ledit porte-substrat est constitué de graphite, dans lequel, de préférence, ledit porte-substrat est constitué d'un noyau en graphite recouvert d'un revêtement de carbure de silicium.

9. Porte-substrat selon l'une des revendications précédentes, dans lequel ladite première partie de bouchon de trou d'alésage est constituée de graphite.

10. Porte-substrat selon l'une des revendications précédentes, dans lequel ladite seconde partie de bouchon de trou d'alésage est constituée de graphite.

11. Procédé de fabrication d'un porte-substrat pour une utilisation dans un système de croissance de couches de film mince sur des substrats semi-conducteurs par dépôt chimique en phase vapeur, comprenant les étapes :
- de fourniture d'un porte-substrat (1) ayant un premier côté surface (3), une partie de zone dudit premier côté surface étant munie de supports de substrat (9) pour recevoir, en cours d'utilisation, lesdits substrats semi-conducteurs,
- d'usinage d'une première section de trou d'alésage (11A) dans chacun desdits supports de substrat au moins sensiblement perpendiculairement au premier côté surface du porte-substrat ;
- d'usinage d'une deuxième section de trou d'alésage (11B) à partir d'une surface de paroi (7) circonférentielle du porte-substrat s'étendant radialement à travers ledit porte-substrat pour fournir un raccordement de gaz entre chacune des premières sections de trou d'alésage dans les supports de substrat et une partie centrale (13) du porte-substrat radialement vers l'intérieur des supports de substrat ;
- d'ajustement serré d'une première partie de bouchon de trou d'alésage (15) dans la deuxième section de trou d'alésage ;
- d'usinage d'une poche (25) pour une seconde partie de bouchon de trou d'alésage (17) dans la surface de paroi du porte-substrat, où ladite poche est munie d'un filetage et agencée à un angle par rapport à la direction longitudinale du trou d'alésage de la deuxième section de trou d'alésage (11B)
- de vissage dans la seconde partie de bouchon de trou d'alésage qui est au moins partiellement munie d'une section filetée correspondant audit filetage de ladite poche, pour bloquer ladite première partie de bouchon de trou d'alésage.

12. Procédé de fabrication d'un porte-substrat selon la revendication 11, dans lequel ledit procédé comprend en outre, avant ladite étape d'ajustement serré de ladite première partie de bouchon de trou d'alésage, l'étape :
- d'usinage d'un chanfrein sur ladite surface de paroi dudit porte-substrat.

13. Procédé de fabrication d'un porte-substrat selon l'une des revendications précédentes 11 et 12, dans lequel ladite seconde partie de bouchon de trou d'alésage comprend une section de réception d'outil en forme de polygone s'étendant depuis ladite section de tête et dans lequel ledit procédé comprend en outre, après ladite étape de vissage dans ladite seconde partie de bouchon de trou d'alésage, l'étape :
- d'usinage de ladite surface de paroi dudit porte-substrat en retirant ladite section de réception d'outil s'étendant depuis ladite surface de paroi dudit porte-substrat afin de rendre ladite seconde partie de bouchon de trou d'alésage alignée avec ladite surface de paroi dudit porte-substrat.

14. Procédé de fabrication d'un porte-substrat selon l'une des revendications 11 à 13, dans lequel ledit procédé comprend en outre, après ladite étape de vissage dans ladite seconde partie de bouchon de trou d'alésage, l'étape :
- de fourniture d'un revêtement de carbure de silicium d'au moins ladite surface de paroi dudit porte-substrat, et plus particulièrement de recouvrement de l'ensemble dudit porte-substrat.

15. Procédé de fabrication d'un porte-substrat selon l'une des revendications 11 à 14, dans lequel l'une ou les deux desdites première et seconde parties de bouchon de trou d'alésage est/sont constituée(s) de graphite.
